# EUROPEAN PATENT SPECIFICATION

(11) **EP 1 622 269 B1**
(45) Date of publication and mention of the grant of the patent: **28.03.2012**
(21) Application number: 04027494.6
(22) Date of filing: 19.11.2004
(51) Int. Cl.: H03K 19/0185, H04L 25/02

(54) **Inferface circuit and constituting method thereof**
Schnittstellenschaltung und ein Aufbauverfahren dafür
Circuit d'interface et sa méthode de constitution

(30) Priority: 30.07.2004 JP 2004224798
(43) Date of publication of application: 01.02.2006
(73) Proprietor: FUJITSU LIMITED, Kawasaki-shi, Kanagawa 211-8588 (JP)
(72) Inventor: Tokuhiro, Noriyuki, c/o Fujitsu Limited, Kawasaki-shi Kanagawa 211-8588 (JP); Itoh, Kunihiro, c/o Fujitsu VLSI Limited, Kasugai-shi Aichi 487-0013 (JP)
(74) Representative: Kreutzer, Ulrich

(56) References cited:
- EP-A1- 0 463 316
- US-A1- 2002 005 734
- US-A1- 2003 057 994
- US-A1- 2004 145 393
- US-B1- 6 194 924

## Description

### BACKGROUND OF THE INVENTION

1. Field of the Invention

The present invention relates to an interface circuit used for an interface of a DDR 2 (Double Data Rate 2) memory, and so on. In particular, the present invention relates to an interface circuit which constitutes different function circuits, for example, a driving circuit and a resistance load of an OCD (Off-Chip Driver) circuit, by using structural elements in common, and a constituting method thereof.

2. Description of the Related Art

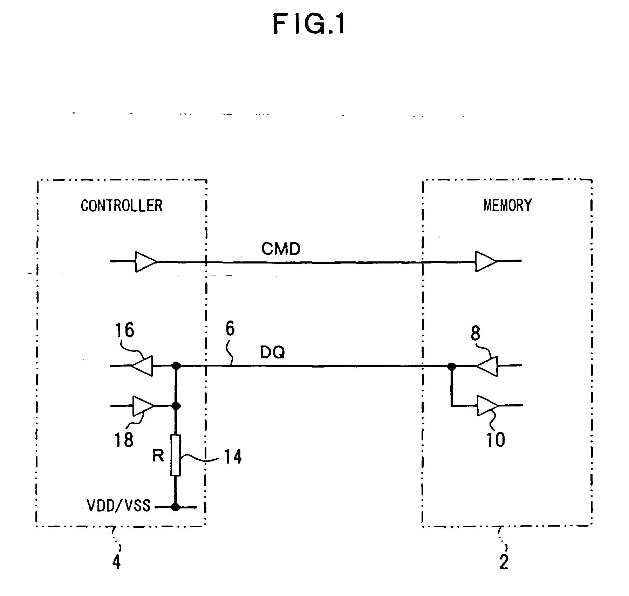

In connection with an interface circuit of the DDR 2 memory, an explanation is given by referring to Fig. 1. Fig. 1 shows a relation of connection between a controller, which constitutes an OCD circuit, and a memory. A memory 2 is connected to an external terminal 6 of a controller 4 which is composed of a controlling LSI (Large Scale Integration), and has a driver circuit 8 and a receiver circuit 10 which are constituted by buffer circuits. On the other hand, to the controller 4, it is necessary to give an OCD function for the purpose of adjusting an output driving capability of the memory 2 as an interface of the memory 2. As the OCD function of the controller 4, it is necessary to adjust the output driving capability on a side of the memory 2 to 18 [Ω]. Further, in order to realize the OCD function, a resistance element 14 is provided as a dummy resistance load for adjustment, and a receiver circuit 16 and a driver circuit 18 are also provided. These receiver circuit 16 and driver circuit 18 are buffer circuits. It is possible to know a driving capability against a memory output of the driver circuit 8 of the memory 2 from an input potential determined by a resistance value R of the resistance element 14 in relation to the memory output.

Further, signals between the memory 2 and the controller 4 are divided broadly into DQ s signal which are bidirectional signals transmitting data, and CMD signals which transmitcommands to the memory 2. signals intended for the OCD are the DQ signals.

By the way, in OCD operation, an optional DC (Direct Current) signal is made to output from the memory 2 by using the CMD signal, and this DC signal is made to pull up or pull down by the resistance element 14 on a side of the controller 4. In case in which an H (High level) output has been taken out from the memory 2, a current is drawn out from the memory by making the resistance element 14 pull down, whether or not terminal potential is larger than a voltage VDD/2 of one-half of a voltage VDD is discriminated by the receiver circuit 10. By this, it is possible to adjust a driving capability on a side of a P-channel transistor which is provided in the driver circuit 8 inside the memory 2. On the other hand, in case in which an L (Low level) output has been taken out from the memory 2, by pulling up the resistance element 14, it is possible to adjust a driving capability on a side of an N-channel transistor of the driver circuit 8 inside the memory 2.

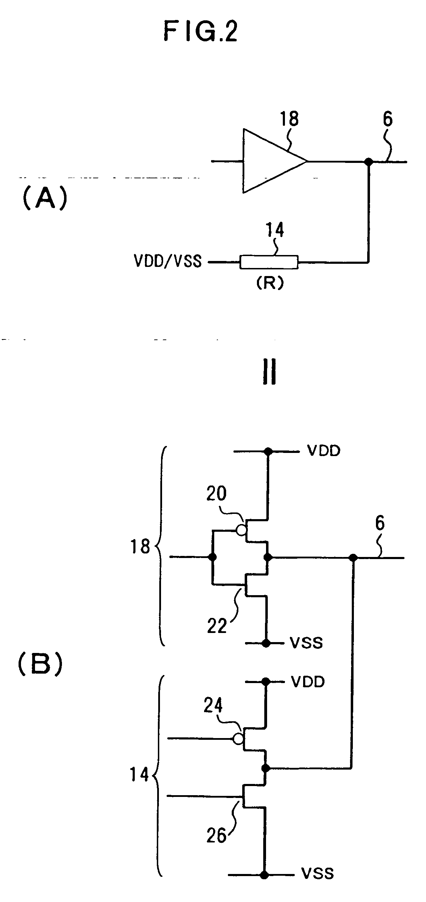

Further, as shown in (A) of Fig. 2, the resistance element 14 for the OCD operation is provided adjacently to the driver circuit 18. As shown in (B) of Fig. 2, the driver circuit 18 is constituted by a TrP (P-channel field effect transistor) 20 and a TrN (N-channel field effect transistor) 22, and the resistance element 14 is constituted by a TrP (P-channel field effect transistor) 24 and a TrN (N-channel field effect transistor) 26. In order to obtain the necessary resistance value R, a gate voltage of each of the TrP 24 and TrN 26 is controlled to a predetermined value.

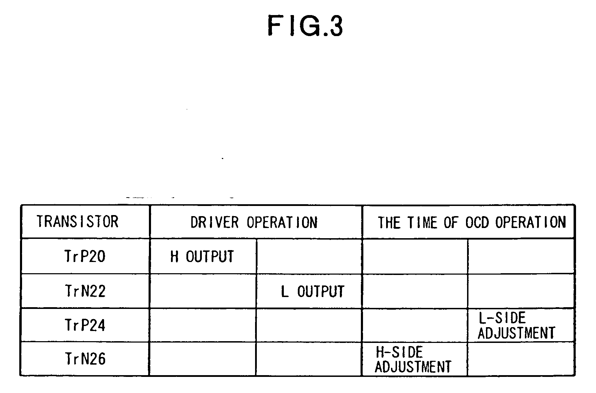

In connection with the resistance element 14 and the driver circuit 18 mentioned above, operation of the TrP 20 and TrN 22 and operation of the TrP 24 and TrN 26 are shown in Fig. 3. As shown in Fig. 3, in case of making it function as a driver circuit (driver operation) , an H output is obtained from the TrP 20, and an L output is obtained from the TrN 22. On the other hand, in case of functioning as the OCD (OCD operation), the adjustment of an L (Low level) side is performed with the TrP 24, and the adjustment of an H (High level) side is performed with the TrN 26. Like this, in case in which the resistance element 14 provided together on the driver circuit 18 is constituted by the TrP 24 and the TrN 26, if the driver function or the OCD function is realized selectively, in the driver operation the TrP 20 and the TrN 22 only become an operating state, and the other TrP 24 and TrN 26 are removed from an operating group. On the other hand, in the OCD operation, the TrP 24 and the TrN 26 only become an operating state, and the other TrP 20 and TrN 22 are removed from an operating group. The TrP 24 and the TrN 26 which constitute the resistance element 14 are to be concerned in the external terminal 6 as a parasitic capacity at the time of being removed from an operating group.

By the way, as patent documents in respect to an OCD circuit and so on, the Japanese Laid Open Publications No.H04-290008 and No.H10-105307 are in existence.

In the publication No.H04-290008, as an off-chip driver (OCD) circuit, a constitution which interfaces between a first circuit having a predetermined supply voltage and a second circuit having a supply voltage higher than the first circuit is disclosed.

The publication No.H10-105307 discloses an OCD circuit as a driver and receiver circuit.

By the way, in connection with the constitution of Fig. 2 described before, in case of being not functioning as the OCD, the TrP 24 and the TrN 26 which are made to function as the resistance element 14 are added to the external terminal 6 as a capacitive component, and a capacity C of the external terminal 6 is made to increase. In a circuit element of a transistor and so on, various kinds of capacities such as an inter-terminal capacity and an electrostatic capacity of the inside of an element are in existence. Because of this, if such a circuit element exists, an electrostatic capacity of the external terminal is to increase according to the number of elements like this. Such an increase of an electrostatic capacity is to make a circuit characteristic worse. In connection with such a disadvantage, there is no mention in the above-mentioned publications No.H04-290008 and No.H10-105307 which disclose an OCD, and a constitution which solves it as a problem is not disclosed or suggested, either.

US 2002/005734 A1 shows a programmable active termination circuit comprising:
- a plurality of first transistors of a first type;
- a plurality of second transistors of a type complementary to the first type;
- a communication line for receiving and transmitting signals, the communication line being coupled to the primary current carrying ports of each of the first and second transistors; and
- means for selectively activating a subset of the first and/or second transistors via their respective control ports to create a desired impedance value as seen from the communication line.

EP 0 463 316 A1 shows a self-adjusting impedance matching driver for a digital circuit, driving a load having an unknown impedance within a predetermined range, comprising:
- driver means for driving digital signals to a digital circuit, said driver means having a predetermined impedance; said driver means including selectable impedance means for changing said predetermined impedance to a different, selected impedance within said predetermined range; and
- means coupled to said driver means for sensing the impedance difference between the output of said driver means and the digital circuit and for modifying automatically said selectable impedance means to a different impedance to obtain the optimum impedance match of said driver means to the digital circuit.

### SUMMARY OF THE INVENTION

The present invention is defined in the claims and relates to an interface circuit which is connected to a function unit such as a memory, and an object of the present invention is to reduce the number of structural elements by using structural elements in common and is also to constitute a plurality of different function circuits.

Furthermore, another object of the present invention is to reduce a capacitive component to an external terminal by reducing the number of connected elements and is to give the improvement of a circuit characteristic.

In order to attain the above objects, an interface circuit of the present invention is a constitution in which structural elements are used for a plurality of circuits in common and necessary functions are obtained by controlling the structural elements. That is, the interface circuit of the present invention is defined in claim 1. In this constitution, the function unit constitutes a memory, for example. According to a constitution like this, the first and second electronic devices are used for the function circuit, which has the different functions, as common structural elements.

By this, a reduction in the structural elements may be given. By such a reduction in the number of elements, the number of elements which are connected to the external terminal of the interface circuit gets fewer. Because of this, a capacitive component to the external terminal decreases, and the improvement of a circuit characteristic may be given.

An interface circuit may be connected with a function unit, and comprise first and second transistors connected in series, and an external terminal, formed at an intermediate connected portion between the first and second transistors, to which the function unit is connected, whereby, with the first transistor and the second transistor, a driver circuit is constituted or a resistance element of an off-chip driver circuit is constituted. According to a constitution like this, since active elements constituting the driver circuit and the resistance element are constituted by common transistors, it is not necessary to individually and independently prepare transistors at every circuit. Because of this, a reduction in the number of structural transistors provided is given, and a capacitive component to the external terminal is also reduced. By this, the improvement of a circuit characteristic may be given.

The above-mentioned resistance element in the interface circuit of the present inventionmaybe constituted so that a necessary resistance value is set by controlling one of the first transistor or the second transistor or both of the first transistor and the second transistor. Further, the above-mentioned driver circuit may be constituted so that an output adjustment is executed by controlling one of the first transistor or the second transistor or both of the first transistor and the second transistor.

The interface circuit comprises first and second transistors connected in series, an external terminal, formed at an intermediate connected portion between the first and second transistors, to which an outside function unit is connected, first, second, third and fourth switches which are provided between a gate of the first or second transistor and different first, second and third inputs to be given to these gates, and a switch controlling part which makes all of the first switch through the fourth switch non-conductive or makes one or more of these conductive, and so that different function circuits are constituted by making both of the first and second transistors non-conductive, by making both of the first and second transistors conductive, or by making either the first transistor or the second transistor conductive. Further, in a constitution like this, although various kinds of electronic devices and so on can be used as the above-mentioned switches, the above-mentioned switches may be constituted by analog switches which are controlled by control signals from the switch controlling part.

Furthermore, in order to attain the above objects, the interface circuit of the present invention may also be constituted so that the above-mentioned first input is a driver input to the gates of the first transistor and the second transistor, so that the above-mentioned second input is a bias input to the gate of the first transistor, and so that the above-mentioned third input is a bias input to the gate of the second transistor.

An interface circuit which is provided on a side of a controller connected to a memorymay comprise first and second transistors connected in series, an external terminal, formed at an intermediate connected portion between the first and second transistors, to which the memory is connected, and a switching part which is provided between a gate of the first or second transistor and a plurality of different inputs to be given to these gates, and so that, by selecting the above-mentioned input to the gate of the first transistor or the second transistor through a changeover of the switching part, a driver circuit or a resistance element of an off-chip driver circuit which is connected to the external terminal is constituted. According to a constitution like this, it is possible to reduce the number of transistors connected to the external terminal. Because of this, a capacity of the external terminal can be reduced, and a circuit characteristic may be improved.

In order to attain the above objects, an operating method of an interface circuit according to the present invention is defined in claim 4. By an operating method like this, the function circuit part having the different functions by means of the first and second electronic devices is constituted, namely, a plurality of function circuits is constituted, and electronic devices which are connected to the external terminal get fewer. Because of this, it is possible to reduce an electrostatic capacity formed at the external terminal, and a circuit characteristic may be improved.

A constituting method of an interface circuit connected with a function unit may also be constituted as a method which comprises providing first and second transistors which are connected in series and are also connected to an external terminal, and constituting a driver circuit or a resistance element of an off-chip driver circuit by switching operation of the first and second transistors.

A constituting method of an interface circuit connected with a function unit may also be constituted as a method which comprises connecting first and second transistors in series, forming an external terminal, to which an outside function unit is connected, at an intermediate connected portion between the first transistor and the second transistor, providing a switching part between a gate of the first or second transistor and a plurality of different inputs to be given to these gates, and constituting a resistance load of an off-chip driver or an output driver by selecting the above-mentioned input to a gate of the first transistor or the second transistor through a changeover of the switching part.

A method comprises connecting first and second transistors in series, forming an external terminal, to which an outside function unit is connected, at an intermediate connected portion between the first and second transistors, providing first, second, third and fourth switches between a gate of the first or second transistor and different first, second, and third inputs to be given to these gates, making all of the first through fourth switches non-conductive or making one or more of these switches conduct, and constituting different function circuits by making both of the first and second transistors non-conductive, bymakingbothof the first and second transistors conductive, or by making either the first transistor or the second transistor conductive.

A constituting method of an interface circuit provided on a side of a controller connected with a memory may also be constituted as a method which comprises forming first and second transistors connected in series, forming an external terminal, which is connected to the memory, at an intermediate connected portion between the first and second transistors, providing a switching part between a gate of the first or second transistor and a plurality of different inputs to be given to these gates, and constituting a resistance load of an off-chip driver circuit or an output driver, which is connected to the external terminal, by selecting the above-mentioned input to the gate of the first transistor or the second transistor through a changeover of the switching part.

Under an aspect of the present invention a controller connected to a memory has above-mentioned interface circuit.

As described above, the present invention relates to an interface circuit which is constituted by electronic devices such as transistors, and, by using the electronic devices in common, the present invention gives a reduction of electronic devices and also realizes a plurality of function circuits by control of the electronic devices. Because of this, an electrostatic capacity which is parasitic on the external terminal is reduced by the reduction in the number of structural elements, and a circuit characteristic can be improved. Hence, the present invention can be utilized for various kinds of interfaces, and is useful.

Furthermore, enumerating the featured matters and advantages of the present invention, these are as in the following.

(1) According to the interface circuit of the present invention, the electronic devices of transistors and so on are used in common, and a circuit having a plurality of different functions can be constituted by control of the electronic devices. Because of this, it is possible to realize the plurality of different functions by few structural elements, and it is also possible to give a reduction in the number of structural elements.

(2) According to the interface circuit of the present invention, the number of elements connected to the external terminal can be reduced, a capacitive component of the external terminal can be dropped by that reduction, and a circuit characteristic can be improved. Further, for example, in case of being constituted by an integrated circuit device, it is possible to give degrees of freedom in a circuit design, for example, a reduction of packaging density of electronic devices, its miniaturization, and effective utilization of a substrate area.

(3) According to the constituting method of the interface circuit of the present invention, by using the electronic devices of transistors and so on in common and by control of the electronic devices such as transistors, it is possible to constitute a multi-functional interface circuit realizing a plurality of functions.

### BRIEF DESCRIPTION OF THE DRAWINGS

The foregoing and other objects, features and attendant advantages of the present invention will be appreciated as the same become better understood by means of the following description and accompanying drawings wherein:

Fig. 1 is a circuit diagram showing a relation of connection between a controller and a memory;

Fig. 2 is circuit diagrams showing a constitution of a driver circuit and a resistance element of an OCD circuit which are mounted on the controller;

Fig. 3 is a drawing showing operation of transistors constituting the driver circuit and operation of transistors constituting the resistance element;

Fig. 4 is a circuit diagram showing an interface circuit according to a first embodiment;

Figs. 5A, 5B and 5C are circuit diagrams showing a plurality of function circuits which are realized by the interface circuit;

Figs. 6A and 6B are circuit diagrams showing a plurality of function circuits which are realized by the interface circuit;

Fig. 7 is a circuit diagram showing a relation of connection between a controller and a memory according to a second embodiment;

Fig. 8 is a circuit diagram showing operation of an interface circuit;

Fig. 9 is a circuit diagram showing operation of an interface circuit;

Fig. 10 is a circuit diagram showing operation of an interface circuit;

Fig. 11 is a circuit diagram showing operation of an interface circuit;

Fig. 12 is a circuit diagram showing operation of an interface circuit;

Fig. 13 is a circuit diagram showing operation of an interface circuit;

Fig. 14 is a circuit diagram showing operation of an interface circuit;

Fig. 15 is a circuit diagram showing an interface circuit according to a third embodiment;

Fig. 16 is a circuit diagram showing a controller according to a fourth embodiment;

Fig. 17 is a circuit diagram showing a logical circuit;

Fig. 18 is a circuit diagram showing an interface circuit;

Fig. 19 is a circuit diagram showing an interface circuit; and

Fig. 20 is a drawing showing operation.

### DETAILED DESCRIPTION OF THE PREFERRED EMBODIMENTS

First Embodiment

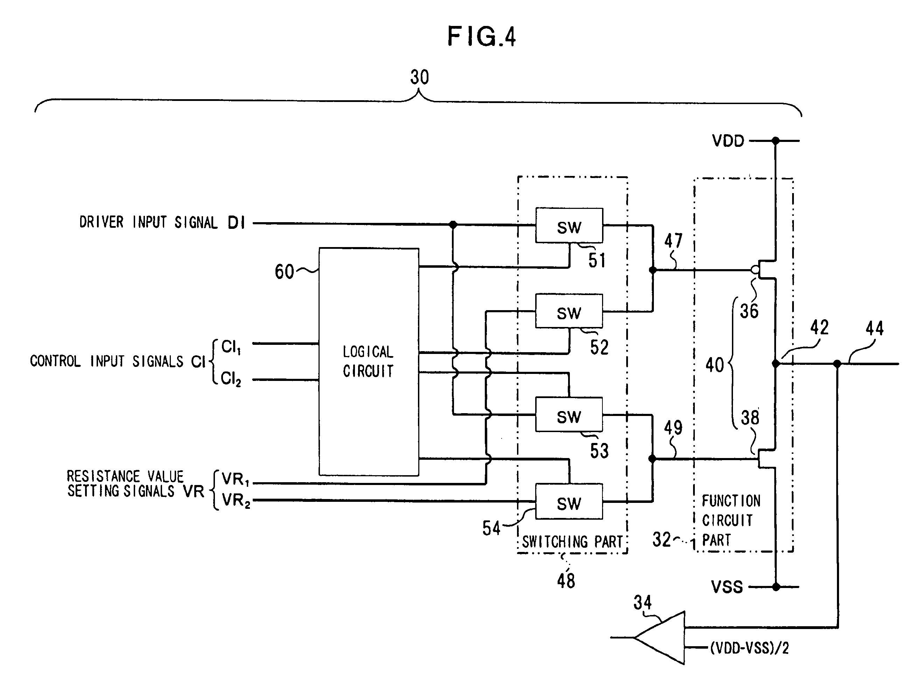

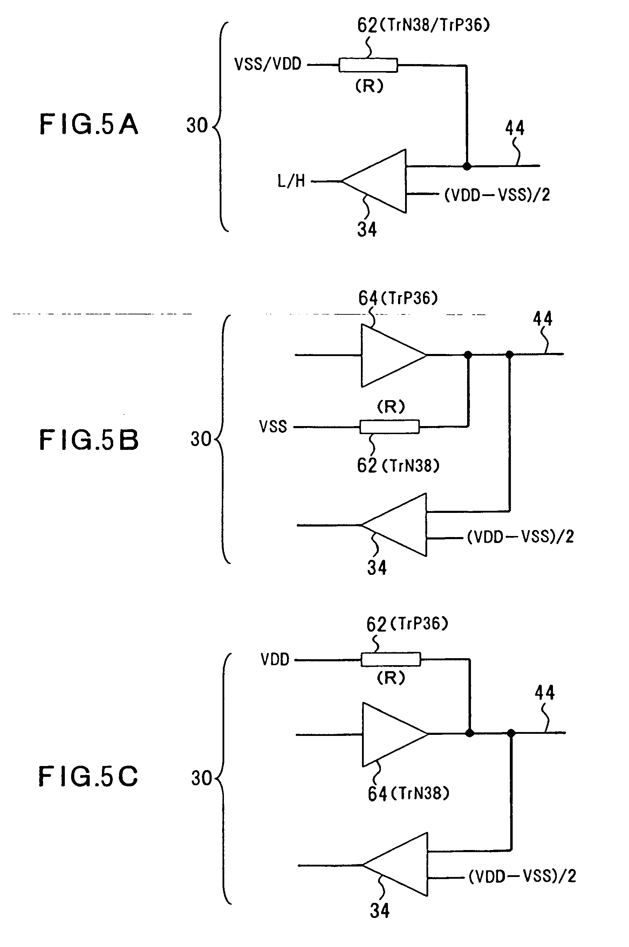

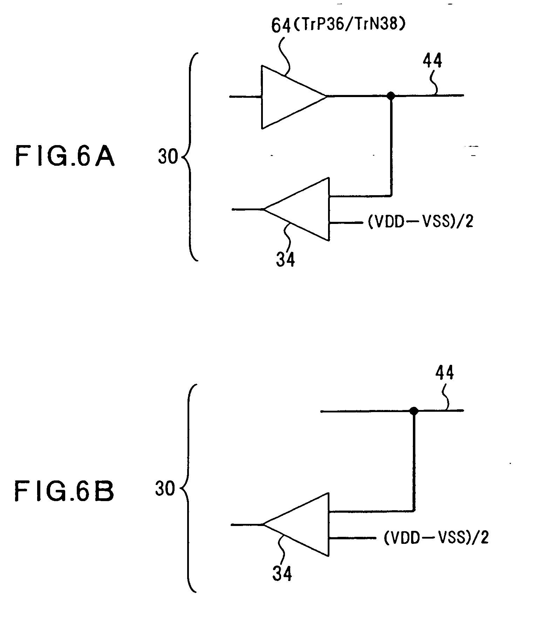

A first embodiment of the present invention is explained by referring to Fig. 4, Fig. 5 and Fig. 6. Fig. 4 shows an interface circuit and a constituting method thereof according to the first embodiment of the present invention, and Fig. 5 and Fig. 6 show function circuits which are realized by this interface circuit.

In this interface circuit 30, a function circuit part 32 is provided in order to constitute a function circuit having a plurality of different functions such as a driver circuit and a resistance element, and a receiver circuit 34 and so on are also provided. In the function circuit part 32, a first transistor 36 is provided as a first active element or as a first electronic device, and a second transistor 38 is provided as a second active element or as a second electronic device. In this embodiment, the transistor 36 is constituted by a P-channel FET (Field Effect Transistor), and the transistor 38 is constituted by an N-channel FET (Field Effect Transistor). Hereinafter, the transistor 36 is called a TrP 36, and the transistor 38 is called a TrN 38. These TrP 36 and TrN 38 are connected in series and constitute a transistor pair 40. For example, this transistor pair 40 can be constituted by a CMOS (Complementary Metal Oxide Semiconductor) circuit. Further, by a power source not shown in the drawings, a voltage VDD is impressed upon a drain of the TrP 36, and a voltage VSS (< VDD) is impressed upon a source of the TrN 38. Furthermore, an external terminal 44 is formed at an intermediate connected portion 42 between the TrP 36 and the TrN 38, and a function unit such as a memory not shown in the drawings is connected thereto. In this case, one input terminal of the receiver circuit 34 is connected to the external terminal 44, and a voltage {(VDD-VSS)/2} is applied to the other terminal thereof. The receiver circuit 34 is constituted by a transistor differential amplifier and so on.

Input terminal parts 47 and 49 are set at each gate of the TrP 36 and the TrN 38, respectively. These input terminal parts 47 and 49 are used as both input terminals for the purpose of making the transistor pair 40 function as a driver circuit and input terminals for the purpose of setting a resistance value in order to function as an OCD circuit. Therefore, a switching part 48 is provided between the input terminal parts 47 and 49 and a side of input signals . This switching part 48 is constituted by a first switch (SW) 51, a second switch (SW) 52, a third switch (SW) 53 and a fourth switch (SW) 54. To the gate of the TrP 36, a driver input signal DI is given through the SW 51, and a resistance value setting signal VR₁ is given through the SW 52. To the gate of the TrN 38, the driver input signal DI is given through the SW 53, and a resistance value setting signal VR₂ is given through the SW 54. That is, the driver input signal DI constitutes a first input to the gates of the TrP 36 and the TrN 38, the resistance value setting signal VR₁ constitutes a second input to the gate of the TrP 36, and the resistance value setting signal VR₂ constitutes a third input to the gate of the TrN 38. The driver input signal DI is an input for the purpose of constituting either the TrP 36 or the TrN 38 or both of the TrP 36 and the TrN 38 as the driver circuit, and the resistance value setting signals VR (= VR₁, VR₂) are bias inputs for the purpose of making the TrP 36 or the TrN 38 function as a resistance element.

Furthermore, a logical circuit 60 is provided as a switch controlling part. The logical circuit 60 receives control input signals CI, generates switch controlling outputs as logical outputs, and gives them to the SWs 51, 52, 53 and 54. In this embodiment, by means of the switch controlling outputs generated by control input signals CI₁ and CI₂, all of the SWs 51, 52, 53 and 54 are made non-conductive, and one or more of these are selectively made conductive.

According to a constitution like this, the function circuit part 32 which is provided in the interface circuit 30 is constituted by the single transistor pair 40 composed of the TrP 36 and the TrN 38, and is constituted as the driver circuit or the resistance element of the OCD circuit by means of this transistor pair 40. Therefore, to the function circuit part 32, the driver input signal DI is given as an input for the purpose of making the transistor pair 40 function as the driver circuit, and the resistance value setting signals VR are also given as inputs for the purpose of setting the resistance value in order to function as the OCD. By the outputs which are obtained by logical operation of the logical circuit 60 due to the control input signals CI, these inputs are selected by selective conductivity or non-conductivity of the SWs 51 though 54, and are transmitted to the transistor pair 40 connected to the external terminal 44. By this, desired operation is executed. For example, in case in which the function circuit part 32 functions as an ordinary driver circuit, the resistance value setting signals VR for the OCD are annulled, and logic according to the driver input signal DI is output. On the other hand, in case in which the function circuit part 32 operates as an OCD circuit, the driver input signal DI is annulled, and the function circuit part 32 functions as the resistance element having a resistance value for OCD operation by an action according to the resistance value setting signals VR. Describing these actions in detail, these are as in the following.

If the SW 52 is conducted, the resistance value setting signal VR₁ is applied to the gate of the TrP 36 through the SW 52, and, if the SW 54 is conducted, the resistance value setting signal VR₂ is applied to the gate of the TrN 38 through the SW 54. In this case, by means of the TrP 36 or the TrN 38, as shown in Fig. 5A, a resistance element 62 is constituted and is provided together on the receiver circuit 34. In this resistance element 62, the VDD represents the time of operation of the TrP 36, and the VSS represents the time of operation of the TrN 38. Further, a resistance value R of the resistance element 62 is set to, for example, 18 [Ω], by means of values of the resistance value setting signals VR₁ and VR₂.

Next, if the SW 51 and the SW 54 are conducted, the driver input signal DI is given to the gate of the TrP 36, and, simultaneously with this, the resistance value setting signal VR₂ is given to the gate of the TrN 38. In this case, by means of the TrP 36 and the TrN 38, as shown in Fig. 5B, a driver circuit 64 is constituted by the TrP 36, and the resistance element 62 is constituted by the TrN 38.

Next, if the SW 52 and the SW 53 are conducted, the resistance value setting signal VR₁ is given to the gate of the TrP 36, and, simultaneously with this, the driver input signal DI is given to the gate of the TrN 38. In this case, by means of the TrP 36 and the TrN 38, as shown in Fig. 5C, the driver circuit 64 is constituted by the TrN 38, and the resistance element 62 is constituted by the TrP 36.

Next, if the SW 51 and the SW 53 is conducted, the driver input signal DI is given to the gates of the TrP 36 and the TrN 38. In this case, by means of the TrP 36 and the TrN 38, as shown in Fig. 6A, the driver circuit 64 is constituted, and this driver circuit 64 is provided together on the receiver circuit 34.

Next, in case in which all of the SW 51 through the SW 54 are not conducted, the TrP 36 and the TrN 38 become a non-conductive state, and, as shown in Fig. 6B, only the receiver circuit 34 is given.

Like this, by means of the function circuit part 32 which is constituted by the transistor pair 40 composed of the TrP 36 and the TrN 38, only the resistance element 62 is constituted (Fig. 5A), the resistance element 62 and the driver circuit 64 are constituted (Fig. 5B and Fig. 5C), or only the driver circuit 64 is constituted (Fig. 6A). Further, none of these resistance element 62 and driver circuit 64 is constituted, and only the receiver circuit 34 is given (Fig. 6B). Hence, making a multi-function by means of a limited number of elements is realized. According to a constitution like this, since the multi-function is given by the TrP 36 and the TrN 38 of the interface circuit 30, a reduction in the number of elements is given as compared with a conventional circuit. Furthermore, since the transistor pair 40 and the receiver circuit 34 only are connected to the external terminal 44, the number of elements connected to the external terminal 44 gets fewer. Because of this, an electrostatic capacity which occurs in case of constituting the driver circuit 18 and the resistance element 14 by using separate elements as described before in Fig. 1 and Fig. 2 is greatly reduced.

Second Embodiment

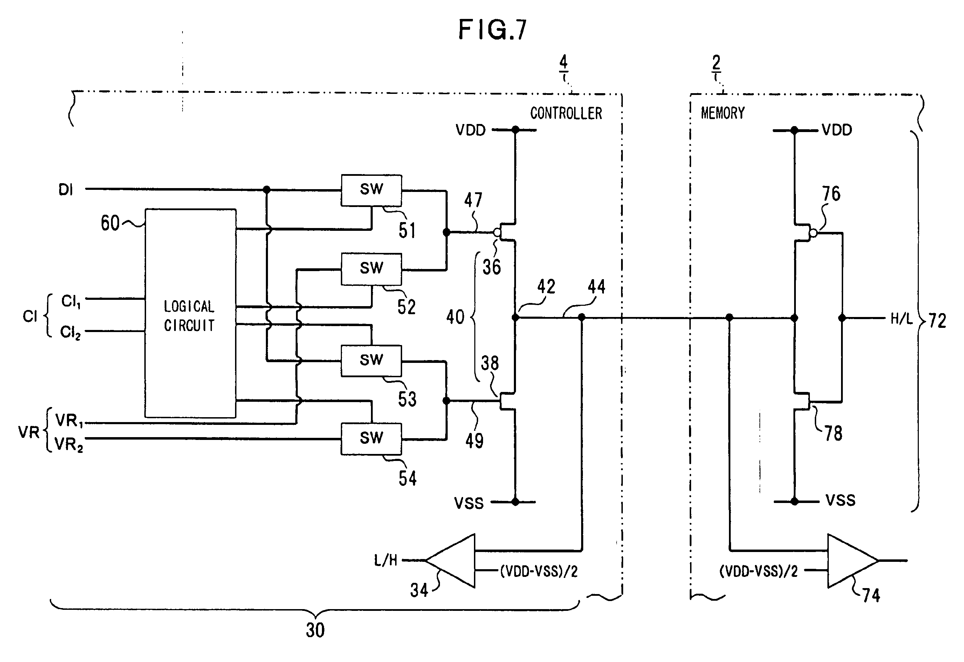

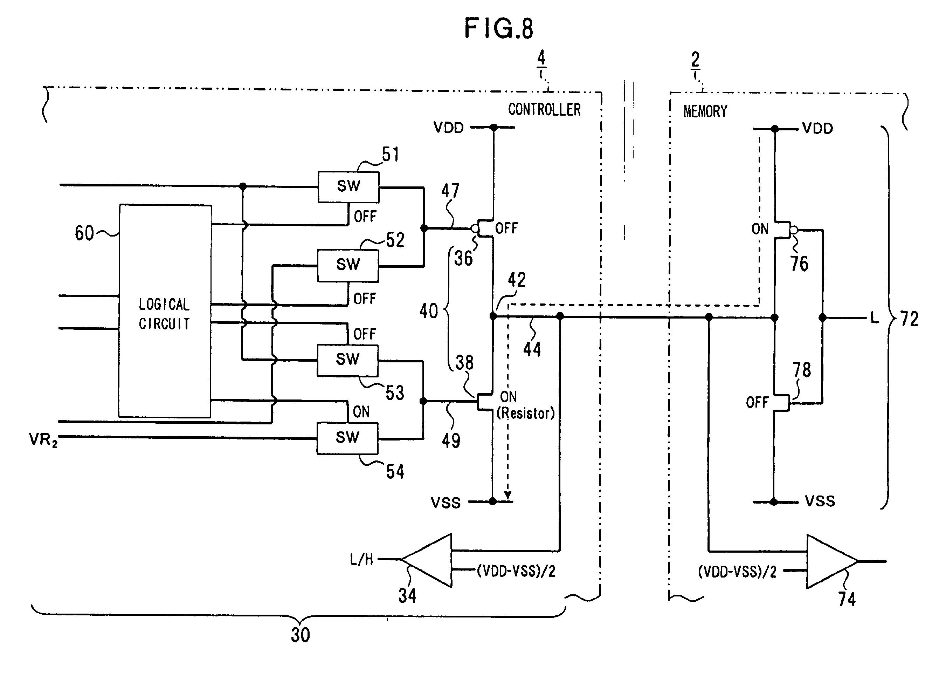

A second embodiment of the present invention is explained by referring to Fig. 7 through Fig. 14. Fig. 7 shows a connection structure between a controller and a memory according to the second embodiment of the present invention, and Fig. 8, Fig. 9, Fig. 10, Fig. 11, Fig. 12, Fig. 13 and Fig. 14 show operation of this interface circuit. The same portions as those of the first embodiment are indicated by the same reference numerals.

For a memory 2, a DDR 2 memory or the like is used, and a driver circuit 72 and a receiver circuit 74 are provided. The driver circuit 72 is constituted by connecting a TrP 76 and a TrN 78 in series. The voltage VDD is applied to a drain of the TrP 76, and the voltage VSS is applied to a source of the TrN 78. Gates of the TrP 76 and the TrN 78 are made common. To this common gate, an H (High level) input or an L (Low level) input is given. Further, an intermediate connected portion between the TrP 76 and the TrN 78 is connected to the external terminal 44 of a controller 4.

Furthermore, in the controller 4, the interface circuit 30 described before is provided. Its constitution is as described in Fig. 4 (the first embodiment).

In a constitution like this, along with its operation, a constituting method of a plurality of function circuits which are constituted in the interface circuit 30 is explained.

If the SW 54 is conducted by an output of the logical circuit 60, the resistance value setting signal VR₂ is given to the gate of the TrN 38 through the SW 54. By this, the TrN 38 is conducted, and, as shown in Fig. 5A, the resistance element 62 pulled down by the voltage VSS is constituted. At this time, the TrP 36 is in a non-conductive state. If the L input is applied to the gates of the TrP 76 and the TrN 78 of the memory 2, the TrP 76 becomes a conductive state, and the TrN 78 becomes a non-conductive state. In this case, a capability adjustment of the TrP 76 of the driver circuit 72 on a side of the memory 2 is performed, and, as shown in Fig. 8, a current flows into the TrN 38 through the external terminal 44 from the TrP 76. A broken line and an arrow indicate that current and direction.

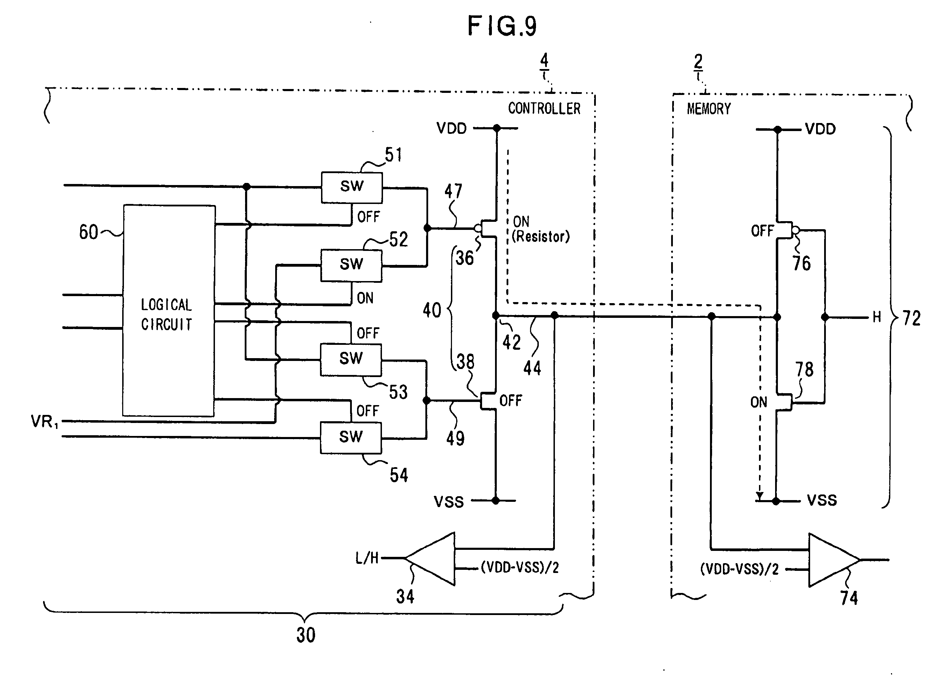

If the SW 52 is conducted by an output of the logical circuit 60, the resistance value setting signal VR₁ is given to the gate of the TrP 36 through the SW 52. Because of this, the TrP 36 is conducted, and, as shown in Fig. 5A, the resistance element 62 pulled up by the voltage VDD is constituted. At this time, the TrN 38 is in a non-conductive state. If the H input is given to the gates of the TrP 76 and the TrN 78 of the memory 2, the TrN 78 becomes a conductive state, and the TrP 76 becomes a non-conductive state. In this case, a capability adjustment of the TrN 78 of the driver circuit 72 on the side of the memory 2 is performed, and, as shown in Fig. 9, a current flows into the TrN 78 through the external terminal 44 from the TrP 36.

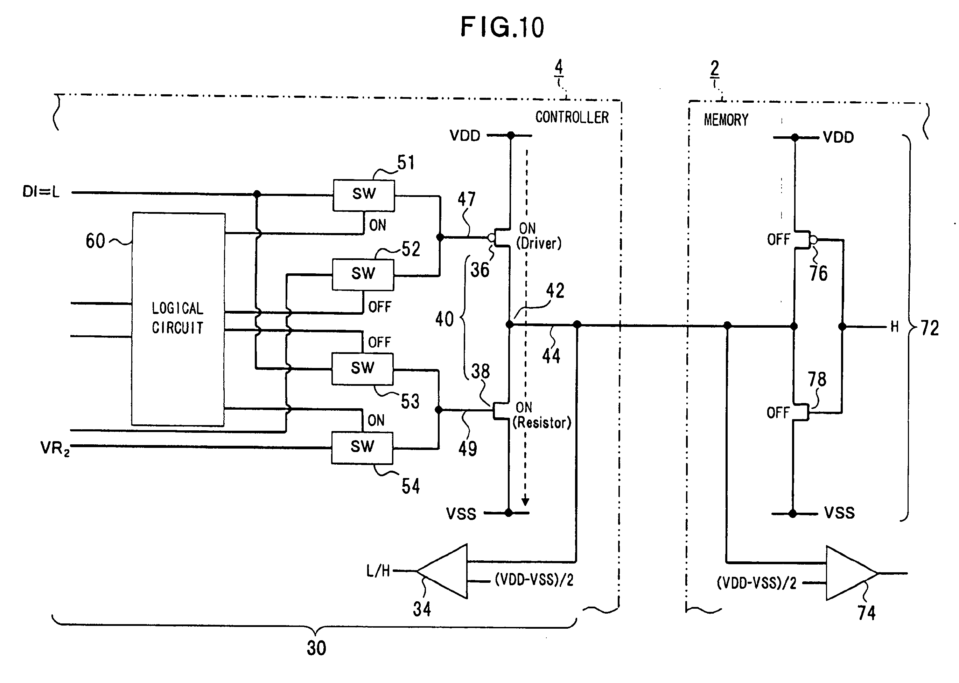

The SW 51 and the SW 54 are conducted at the same time by outputs of the logical circuit 60. In addition to this, an L (Low level) input is given as the driver input signal DI to the gate of the TrP 36 through the SW 51, and the resistance value setting signal VR₂ is given to the gate of the TrN 38 through the SW 54. If such a state is given, as shown in Fig. 5B, the TrP 36 is conducted and the driver circuit 64 is constituted, and the TrN 38 is conducted and the resistance element 62 pulled down by the voltage VSS is also constituted. In this case, if both of the TrP 76 and the TrN 78 on the side of the memory 2 are in the non-conductive state, a current flows through the TrN 38, which is the resistance element, from the TrP 36 which is the driver circuit, as shown in Fig. 10. In this case, the OCD circuit is constituted on a side of the controller 4, and a capability adjustment of the TrP 36 is performed. At this time, an L (Low level) output or an H (High level) output is obtained from the receiver circuit 34.

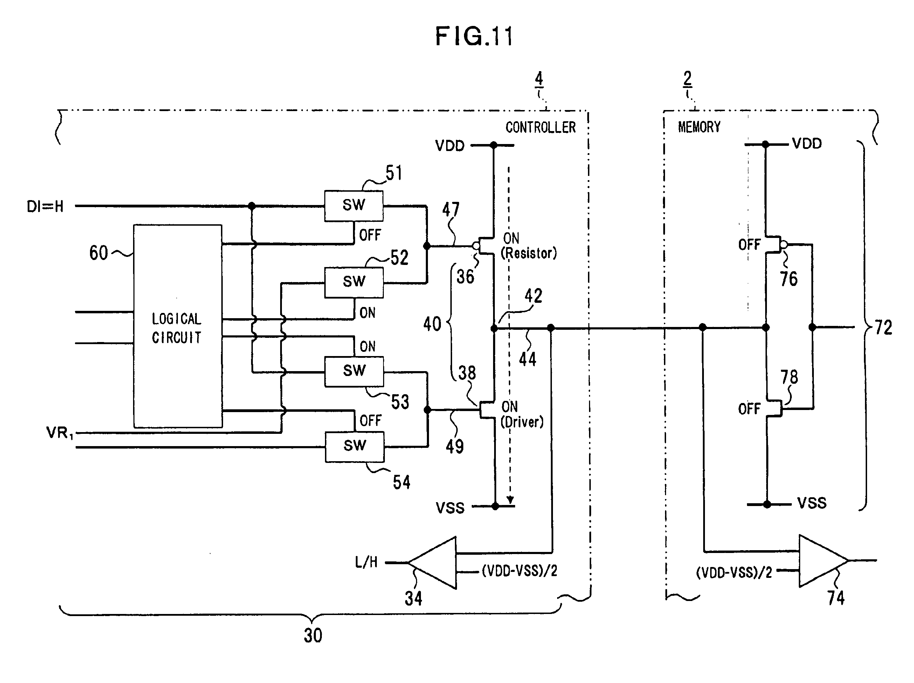

The SW 52 and the SW 53 are conducted at the same time by outputs of the logical circuit 60. In addition to this, the resistance value setting signal VR₁ is given to the gate of the TrP 36 through the SW 52, and an H (High level) input is given as the driver input signal DI to the gate of the TrN 38 through the SW 53. If such a state is given, as shown in Fig. 5C, the resistance element 62 pulled up by the voltage VDD is constituted by the TrP 36, and the driver circuit 64 is constituted by the TrN 38. In this case, if both of the TrP 76 and the TrN 78 on the side of the memory 2 are in the non-conductive state, a current flows through the TrN 38, which is the driver circuit, from the TrP 36 which is the resistance element, as shown in Fig. 11. In this case, the OCD circuit is constituted on the side of the controller 4, and a capability adjustment of the TrN 38 is performed. At this time, the L output or the H output is obtained from the receiver circuit 34.

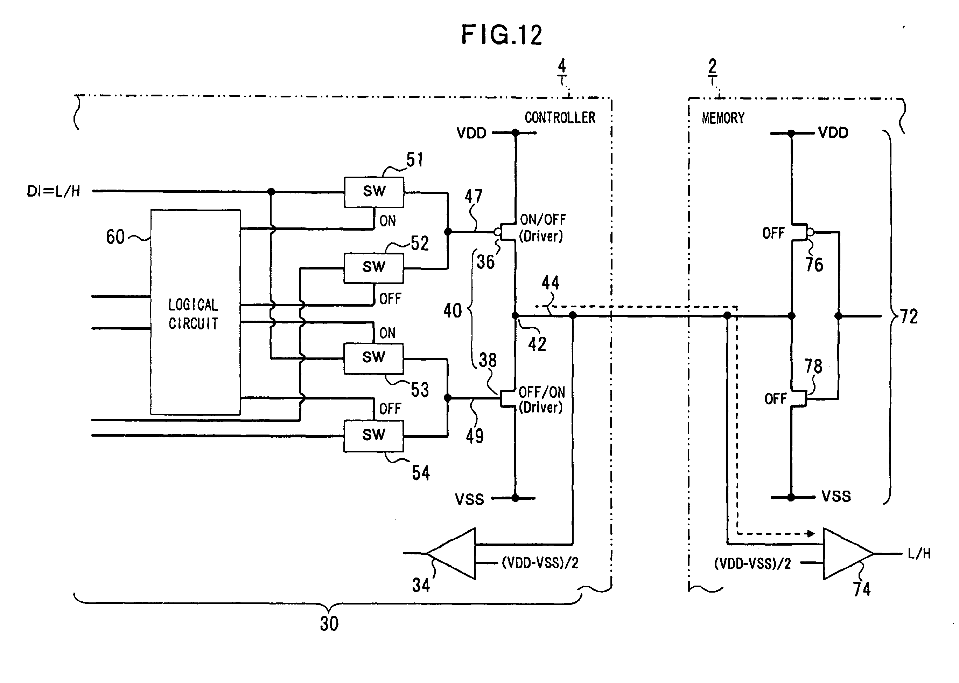

The SW 51 and the SW 53 are conducted at the same time by outputs of the logical circuit 60. In addition to this, the L input or the H input is given as the driver input signal DI to the gate of the TrP 36 through the SW 51, and the L input or the H input is given as the driver input signal DI to the gate of the TrN 38 through the SW 53. If such a state is given, the driver circuit 64 is constituted by the TrP 36 or the TrN 38, as shown in Fig. 6A. If both of the TrP 76 and the TrN 78 on the side of the memory 2 are in the non-conductive state, an output on the side of the controller 4 is input to the receiver circuit 74 of the memory 2 from the external terminal 44 of the controller 4, and the L output or the H output is obtained from the receiver circuit 74, as shown in Fig. 12. That is, the controller 4 performs driver operation toward the memory 2.

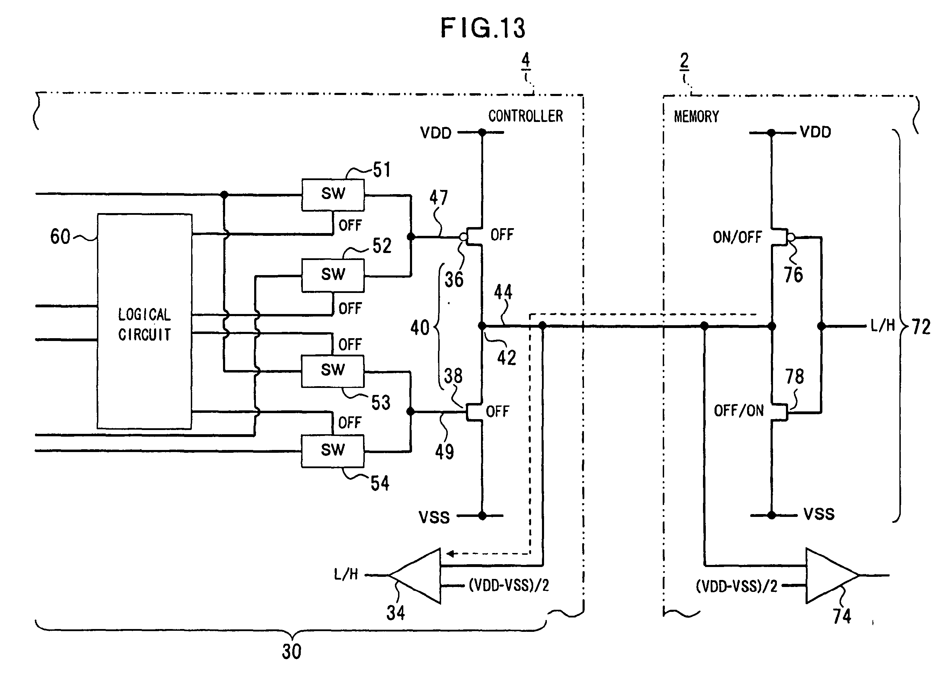

The SW 51 through the SW 54 on the side of the controller 4 are made non-conductive. Further, by applying an L (Low level) input or an H (High level) input to the common gate of the TrP 76 and the TrN 78 on the side of the memory 2, the TrP 76 is made conductive or non-conductive, and the TrN 78 is made conductive or non-conductive. If such a state is given, only the receiver circuit 34 is given to the controller 4, as shown in Fig. 6B described before. In this case, as shown in Fig. 13, the controller 4 comes to receiver operation, and a potential change due to conduction or non-conduction of the TrP 76 or the TrN 78 is applied to the receiver circuit 34 through the external terminal 44 of the controller 4. By this, the L output or the H output according to an output of the memory 2 is obtained from the receiver circuit 34.

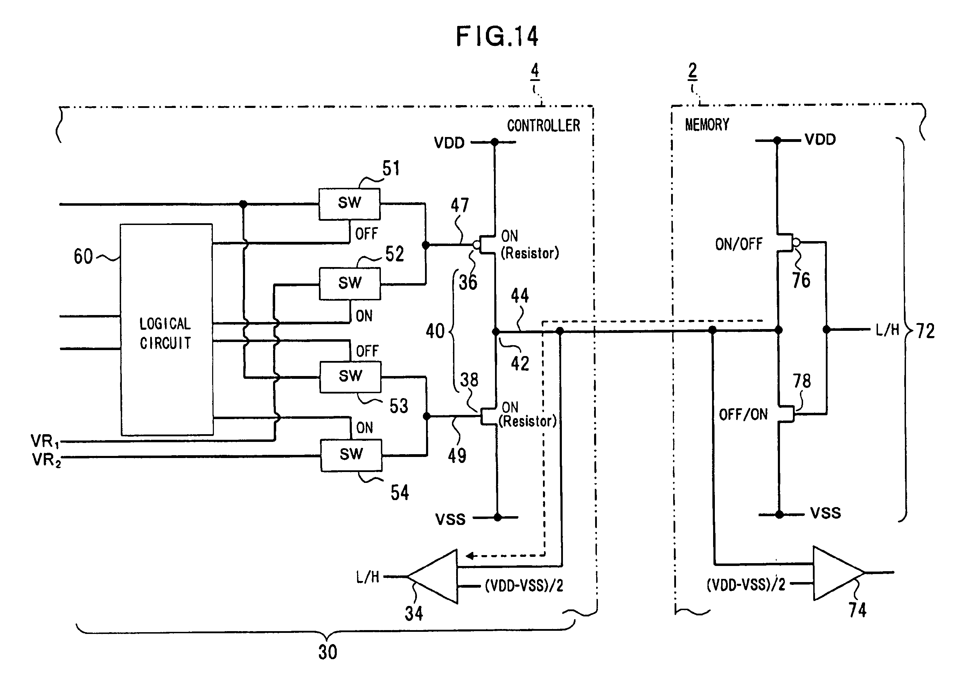

The SW 52 and the SW 54 are conducted at the same time by outputs of the logical circuit 60. In addition to this, the resistance value setting signal VR₁ is applied to the gate of the TrP 36 through the SW 52, and the resistance value setting signal VR₂ is applied to the gate of the TrN 38 through the SW 54. If such a state is given, both of the TrP 36 and the TrN 38 are conducted, and, as shown in Fig. 5A, the resistance element 62 which is pulled up by the voltage VDD or is pulled down by the voltage VSS is constituted by the TrP 36 or the TrN 38. Further, if the L input or the H input is applied to the common gate of the TrP 76 and the TrN 78 on the side of the memory 2, the TrP 76 becomes a conductive state or a non-conductive state, and the TrN 78 becomes a non-conductive state or a conductive state. By this, as shown in Fig. 14, a potential change due to the conduction or the non-conduction of these is given to the receiver circuit 34 through the external terminal 44 of the controller 4, and the L output or the H output according to an output of the memory 2 appears at the receiver circuit 34. In this case, the controller 4 comes to receiver operation which receives the output of the memory 2, the side of the controller 4 makes the TrP 36 and the TrN 38 operate together and the resistance element 62 is constituted as terminating resistance, and an ODT (On Die Termination) function is attained.

As described above, by all of the SWs 51 through 54 being made non-conductive or by one or more of these being made conductive by means of outputs of the logical circuit 60 according to the control input signals CI, and by the driver input signal DI and the resistance value setting signals VR being selectively applied to the gates of the TrP 36 and the TrN 38, the circuits different in a function as shown in Fig. 5 and Fig. 6 are constituted. Since transistors for the purpose of realizing such circuits are only the TrP 36 and the TrN 38, it is possible to reduce the number of structural elements for the realization of functions. Along with this, since the number of elements connected to the external terminal 44 gets fewer, it is possible to lower a capacitive component of the external terminal 44. Furthermore, in case in which the interface circuit 30 is constituted by an integrated circuit device, since the transistors are only the TrP 36 and the TrN 38, an area which occupies its substrate becomes small, and the miniaturization of the substrate is realized. In addition, in case of a substrate with the same area, the enlargement of a circuit mounted on the substrate is given, and the degrees of freedom in a design of a mounted circuit are heightened.

Third Embodiment

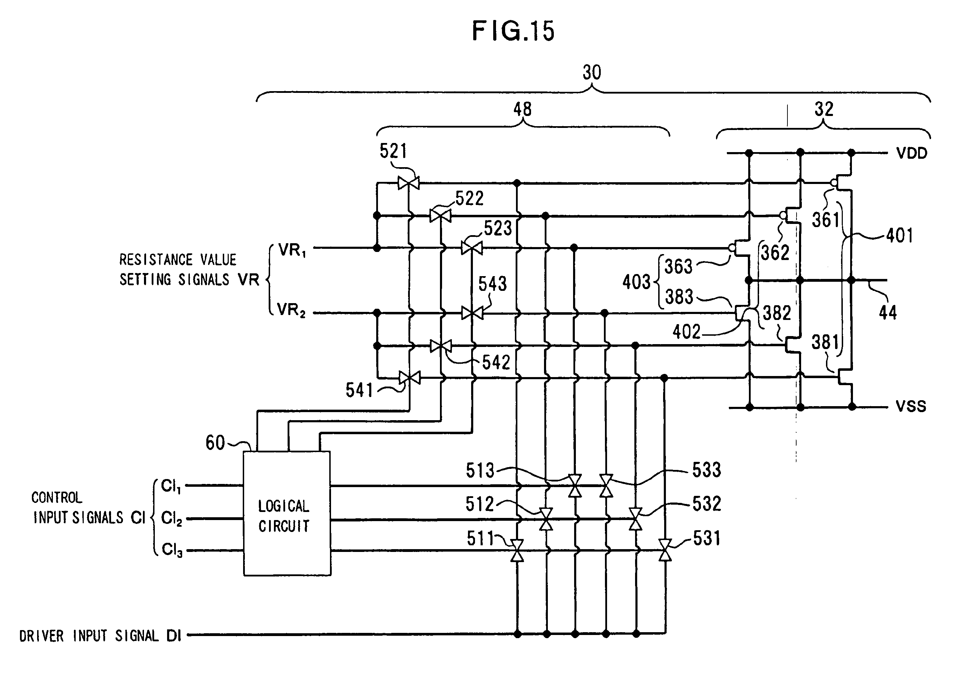

A third embodiment of the present invention is explained by referring to Fig. 15. Fig. 15 shows an interface circuit according to the third embodiment of the present invention.

Although in the first or second embodiment the function circuit part 32 is constituted by the single transistor pair 40 which is constituted by the TrP 36 and the TrN 38, the function circuit part 32 may also be constituted by a plurality of transistor pairs 401, 402 and 403. In this case, the transistor pair 401 is constituted by a TrP 361 and a TrN 381, the transistor pair 402 is constituted by a TrP 362 and a TrN 382, and the transistor pair 403 is constituted by a TrP 363 and a TrN 383.

Further, in order to selectively apply the resistance value setting signals VR₁ and VR₂ and the driver input signal DI to a gate of each of the TrPs 361, 362 and 363 and to a gate of each of the TrNs 381, 382 and 383 in such three sets of the transistor pairs 401 through 403, a switching part 48 may be constituted by SWs (switches) 511, 512, 513, 521, 522, 523, 531, 532, 533, 541, 542 and 543. Furthermore, each of the SWs 511, 512, 513, 521, 522, 523, 531, 532, 533, 541, 542 and 543 of the switching part 48 is selectively switched to a conduction or a non-conduction by logical outputs obtained from a logical circuit 60 by means of control input signals CI₁, CI₂ and CI₃.

Like this, also in case of providing the three sets of the transistor pairs 401 through 403 in the function circuit part 32, it is possible to constitute the function circuits shown in Fig. 5 and Fig. 6 by each of the transistor pairs 401 through 403, similarly. Furthermore, also in this embodiment, as described before, it is possible to give the reduction in the number of structural elements, the reduction of a capacity of the external terminal 44, and so on.

Fourth Embodiment

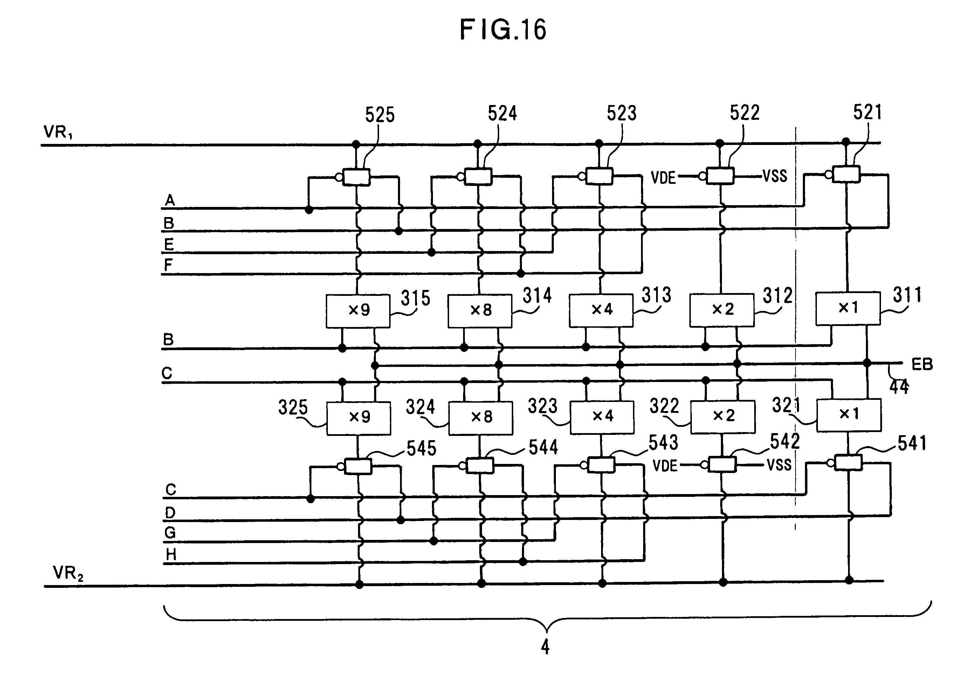

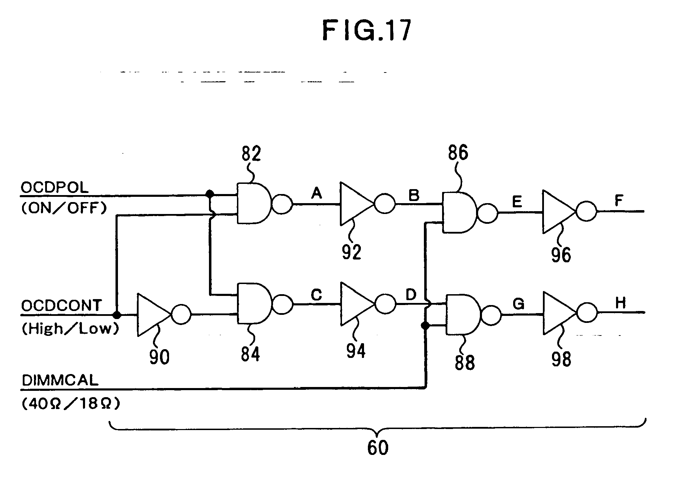

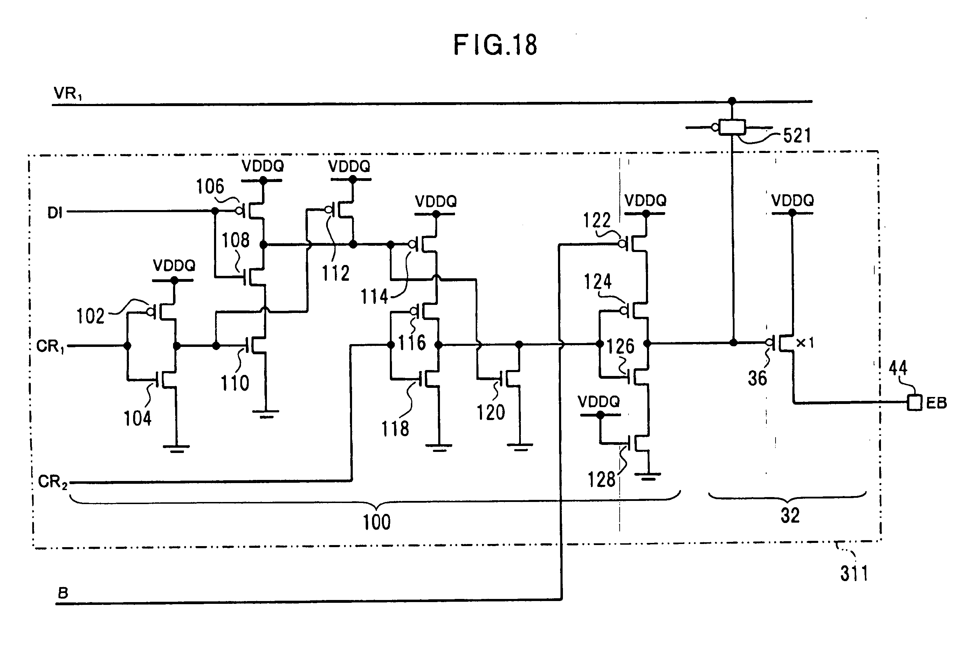

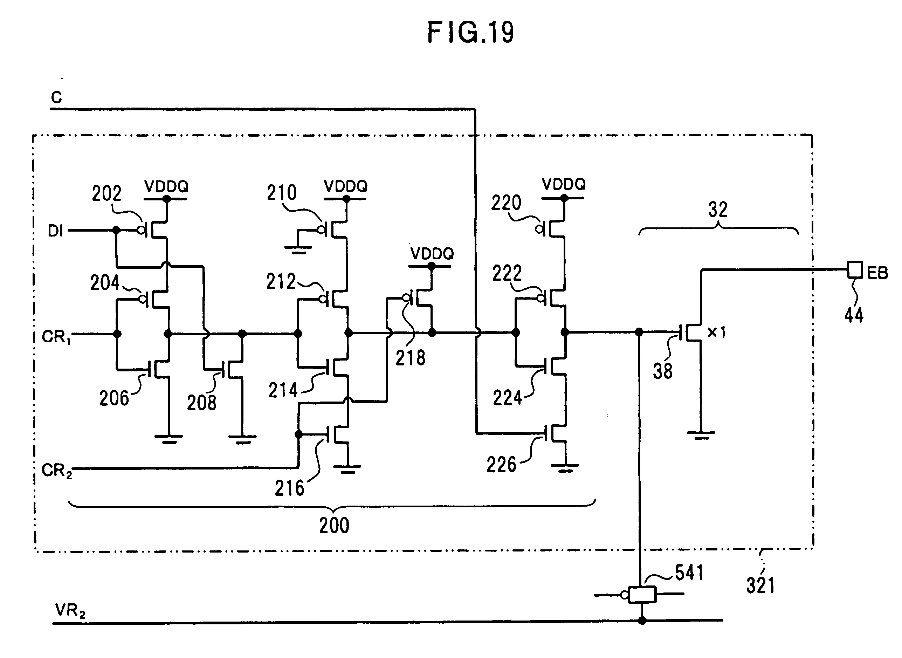

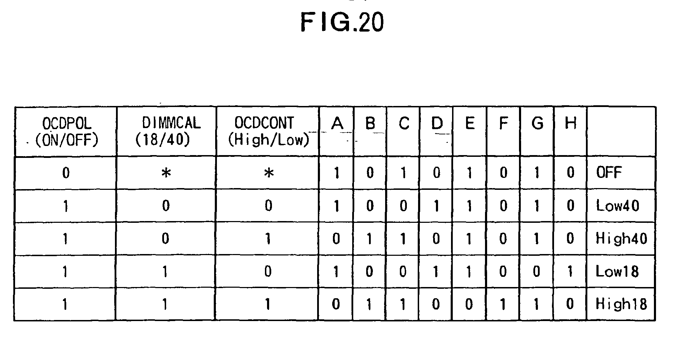

A fourth embodiment of the present invention is explained by referring to Fig. 16 through Fig. 20. Fig. 16 shows a controller according to the fourth embodiment of the present invention, Fig. 17 shows a logical circuit connected to the controller, Fig. 18 shows an interface circuit, Fig. 19 shows an interface circuit, and Fig. 20 shows a truth table.

As shown in Fig. 16, inthis controller 4, a plurality of interface circuits 311, 312, 313, 314 and 315 are provided, a plurality of interface circuits 321, 322, 323, 324 and 325 are provided, SWs (switches) 521, 522, 523, 524 and 525 are provided at the interface circuits 311 through 315 respectively, and SWs (switches) 541, 542, 543, 544 and 545 are provided at the interface circuits 321 through 325 respectively. A reference letter EB constitutes the external terminal 44 (Fig. 4). To the interface circuits 311 through 315, the resistance value setting signal VR₁ is applied through the SWs 521 through 525, and, to the interface circuits 321 through 325, the resistance value setting signal VR₂ is applied through the SWs 541 through 545. Magnification (x1, x2, x4, x8, x9) shown in the interface circuits 311 through 315 and the interface circuits 321 through 325 represents an area of the TrP 36 and the TrN 38 provided in the function circuit part 32, and becomes a characteristic value for the purpose of setting a driving capability and a resistance value. In addition, each of the SWs 521 through 525 and each of the SWs 541 through 545 are constituted by a transistor pair composed of a TrP (P-channel FET) and a TrN (N-channel FET). In this case, the TrNs of the SWs 522 and 542 are set to an OFF state at all times.

Input signals A, B, C, D, E, F, G and H of the controller 4 are formed by a logical circuit 60 shown in Fig. 17. This logical circuit 60 receives an OCD changeover input signal OCDPOL for whether or not to constitute the interface circuits 311 through 315 and the interface circuits 321 through 325 as an OCD circuit, an OCD control signal OCDCONT on the occasion of constituting the OCD circuit, and a resistance value selecting signal DIMMCAL for the purpose of selecting a resistance value which is set in the OCD circuit, and outputs the input signals A through H to the controller 4. The logical circuit 60 in this embodiment is constituted by NAND circuits 82, 84, 86 and 88 and NOT circuits 90, 92, 94, 96 and 98. In addition, the input signals B and C are signals for the purpose of making the TrP 36 and the TrN 38, which constitute a driver circuit of the function circuit part 32, into High-Z (High-impedance) only when constituting the OCD circuit.

In connection with a constitution of each of the interface circuits 311 through 315, for example, an explanation is given by using the interface circuit 311 as an example. As shown in Fig. 18, the TrP 36 of the function circuit part 32 is a provided as a final-stage transistor part, and a pre-driver part 100 is provided at a forward stage of the function circuit part 32. This pre-driver part 100 is constituted by a TrP 102, a TrN 104, a TrP 106, a TrN 108, a TrN 110, a TrP 112, a TrP 114, a TrP 116, a TrN 118, a TrN 120, a TrP 122, a TrP 124, a TrP 126 and a TrN 128, and includes the function of the SW 51 described before. In this interface circuit 311, a reference letter DI is a driver input signal, and reference letters CR₁ and CR₂ are control signals. The driver input signal DI is input to the gate of the TrP 36 by these control signals CR₁ and CR₂, and, in case of taking in the resistance value setting signal VR₁, the function of the pre-driver part 100 is stopped and the gate of the TrP 36 is made to shift to an open state. The other interface circuits 312 through 315 also have the same constitution.

Further, in connection with a constitution of each of the interface circuits 321 through 325, for example, an explanation is given by using the interface circuit 321 as an example. As shown in Fig. 19, the TrN 38 of the function circuit part 32 is a provided as a final-stage transistor part, and a pre-driver part 200 is provided at a forward stage of this function circuit part 32. This pre-driver part 200 is constituted by a TrP 202, a TrP 204, a TrN 206, a TrN 208, a TrP 210, a TrP 212, a TrN 214, a TrN 216, a TrP 218, a TrP 220, a TrP 222, a TrN 224 and a TrN 226, and includes the function of the SW 53 described before. In this interface circuit 321, a reference letter DI is a driver input signal, and reference letters CR₁ and CR₂ are control signals. The driver input signal DI is input to the gate of the TrN 38 by these control signals CR₁ and CR₂, and, in case of taking in the resistance value setting signal VR₂, the function of the pre-driver part 200 is stopped and the gate of the TrN 38 is made to shift to an open state. The other interface circuits 322 through 325 also have the same constitution.

According to a constitution like this, operation as shown in a truth table of Fig. 20 is obtained. In this truth table, "1" is "1"=H (High level), and "0" is "0"=L (Low level). Therefore, in case of obtaining "Low 40", on the occasion of the input signal C="0" and the input signal D="1", the SWs 541 and 545 become conductive, and the other SWs 521 through 525, 542, 543 and 544 become non- conductive. In case of obtaining "High 40", on the occasion of the input signal A="0" and the input signal B="1", the SWs 521 and 525 become conductive, and the other SWs 522, 523, 524 and 541 through 545 become non-conductive. In case of obtaining "Low 18", on the occasion of the input signal C="0", the input signal D="1", the input signal G="0" and the input signal H="1", the SWs 541, 543, 544 and 545 become conductive, and the other SWs 521 through 525 and 542 become non-conductive. Further, in case of obtaining "High 18", on the occasion of the input signal A="0", the input signal B="1", the input signal E="0" and the input signal F="1", the SWs 521, 523, 524 and 525 become conductive, and the other SWs 522 and 541 through 545 become non-conductive.

By the operation mentioned above, as described before, the driver circuit and the resistance element of the OCD circuit are constituted by the function circuit part 32 which is constituted by the transistor pair 40 having minimum transistors namely the TrP 36 and the TrN 38. Hence, the number of structural elements connected to the external terminal 44 can be reduced, and an electrostatic capacity due to this can also be reduced.

Next, in connection with the embodiments mentioned above, modified examples are enumerated in the following.

(1) Although in the above-mentioned embodiments a field effect transistor is exemplified as a structural element, an active element or an electronic device of the function circuit part 32, this may also be constituted by a bipolar transistor, or may also be constituted by an electronic element except a transistor.

(2) Although in the above-mentioned embodiments the interface circuit 30 which is provided on the side of the controller 4 is exemplified, a constitution equal to the interface circuit described before may also be applied to the circuit on the side of the memory 2 which is a function unit.

(3) In the above-mentioned embodiments, the controller 4 which is connected to the memory 2 is disclosed, and an example in which the interface circuit 30 is provided in this controller 4 is explained. However, the interface circuit of the present invention can be applied as an interface between function units requiring an OCD function and a driver function, and is not limited to the circuits of the embodiments.

(4) In the above-mentioned embodiments, constituting the TrP 36, the TrN 38 and so on by the CMOS circuit is exemplified. The interface circuit including the TrP 36, the TrN 38 and so on may also be constituted by a circuit or an element except CMOS. Further, the TrP 36 and the TrN 38 are constituted by a CMOS circuit, and the switching part 48 and the logical circuit 60 which exist at a forward stage side of the TrP 36 and the TrN 38 may also be constituted by a circuit except a CMOS circuit, for example, a bipolar circuit.

Although the best mode for carrying out the invention, the object, the configuration and the operation and effect have been described in detail above, the invention is not limited to such embodiment for carrying out the invention, and it is a matter of course that the invention can be variously changed or modified by a person skilled in the art on the basis of a gist and split of the invention as disclosed in claims and the detailed description of the invention, and such a change or modification, and various conjectured configurations, modified examples and so forth are included in the scope of the invention, and the description of the specification and drawings are not restrictively understood.

The entire disclosure of Japanese Patent ApplicationNo.2004-224798 including specification, claims, drawings and summary are incorporated herein by reference in its entirety.

## Claims

1. An interface circuit which is connected with a function unit (2), comprising:
- a function circuit part (32) comprising
-- one first and one second transistor (36, 38) connected in series; and
-- an intermediate connected portion (42) between said first transistor (36) and said second transistor (38), to which said function unit (2) is connected;
- an external terminal (44), formed at said intermediate connected portion
- a first switch (51) for selecting a first input signal (DI) and for transmitting said first input signal to a gate of said first transistor (36);
- a second switch (52) for selecting a second input signal (VR₁) and for transmitting said second input signal to the gate of said first transistor (36);
- a third switch (53) for selecting said first input signal (DI) and for transmitting said first input signal to a gate of said second transistor (38); and
- a fourth switch (54) for selecting a third input signal (VR₂) and for transmitting said third input signal to the gate of said second transistor (38),
- said first, second and third input signals (DI, VR₁, VR₂) being different from each other,
- a switch controlling part (60) for receiving two control input signals (CI₁, CI₂) and controlling said first, second, third and fourth switches (51, 52, 53, 54) so that both of said first and second transistors (36, 38) are non-conductive or both of said first and second transistors (36, 38) are conductive or either said first transistor (36) or said second transistor (38) is conductive.

2. The interface circuit of claim 1, wherein said first input signal (DI) is a driver input signal, said second input signal (VR₁) is a bias input signal, and said third input signal (VR₂) is a bias input signal.

3. The interface circuit of claim 1, provided on a side of a controller (4) connected to a memory (2), wherein
- said memory (2) is connected to said external terminal (44) as said function unit (2).

4. An operating method of an interface circuit of any of the preceding claims, said operating method being **characterized by** comprising:
- using the first switch (51) for applying the first input signal (DI) to the gate of said first transistor (36);
- using the second switch (52) for applying the second input signal (VR₁) to the gate of said first transistor (36);
- using the third switch (53) for applying said first input signal (DI) to the gate of said second transistor (38); and
- using the fourth switch (54) for applying the third input signal (VR2) to the gate of said second transistor (38);
wherein said first, second and third input signals (DI, VR₁, VR₂) are different from each other;
- and controlling said first through fourth switches (51, 52, 53, 54) such that both of said first and second transistors (36, 38) are non-conductive or both of said first and second transistors (36, 38) are conductive or either said first transistor (36) or said second transistor (38) is conductive.

## Patentansprüche

1. Schnittstellenschaltung, die mit einer Funktionseinheit (2) verbunden ist, umfassend:
- einen Funktionsschaltungsteil (32) mit
-- einem ersten und einem zweiten Transistor (36, 38), die seriell verbunden sind; und
-- einem Zwischenverbindungsabschnitt (42) zwischen dem ersten Transistor (36) und dem zweiten Transistor (38), mit dem die Funktionseinheit (2) verbunden ist;
- einen externen Anschluß (44), der an dem Zwischenverbindungsabschnitt gebildet ist;
- einen ersten Schalter (51) zum Selektieren eines ersten Eingangssignals (DI) und zum Senden des ersten Eingangssignals an ein Gate des ersten Transistors (36);
- einen zweiten Schalter (52) zum Selektieren eines zweiten Eingangssignals (VR1) und zum Senden des zweiten Eingangssignals an das Gate des ersten Transistors (36);
- einen dritten Schalter (53) zum Selektieren des ersten Eingangssignals (DI) und zum Senden des ersten Eingangssignals an ein Gate des zweiten Transistors (38); und
- einen vierten Schalter (54) zum Selektieren eines dritten Eingangssignals (VR2) und zum Senden des dritten Eingangssignals an das Gate des zweiten Transistors (38),
- wobei sich die ersten, zweiten und dritten Eingangssignale (DI, VR1, VR2) voneinander unterscheiden,
- einen Schaltersteuerteil (60) zum Empfangen zweier Steuereingangssignale (CI1, CI2) und Steuern der ersten, zweiten, dritten und vierten Schalter (51, 52, 53, 54) so, daß die beiden ersten und zweiten Transistoren (36, 38) nicht leitend sind oder die beiden ersten und zweiten Transistoren (36, 38) leitend sind oder entweder der erste Transistor (36) oder der zweite Transistor (38) leitend ist.

2. Schnittstellenschaltung nach Anspruch 1, bei der das erste Eingangssignal (DI) ein Treibereingangssignal ist, das zweite Eingangssignal (VR1) ein Vorspannungseingangssignal ist und das dritte Eingangssignal (VR2) ein Vorspannungseingangssignal ist.

3. Schnittstellenschaltung nach Anspruch 1, die auf einer Seite eines Controllers (4) vorgesehen ist, der mit einem Speicher (2) verbunden ist, bei der
- der Speicher (2) mit dem externen Anschluß (44) als die Funktionseinheit (2) verbunden ist.

4. Betriebsverfahren einer Schnittstellenschaltung nach einem der vorhergehenden Ansprüche, welches Betriebsverfahren **dadurch gekennzeichnet ist, daß** es umfaßt:
- Verwenden des ersten Schalters (51) zum Anwenden des ersten Eingangssignals (DI) auf das Gate des ersten Transistors (36);
- Verwenden des zweiten Schalters (52) zum Anwenden des zweiten Eingangssignals (VR1) auf das Gate des ersten Transistors (36);
- Verwenden des dritten Schalters (53) zum Anwenden des ersten Eingangssignals (DI) auf das Gate des zweiten Transistors (38); und
- Verwenden des vierten Schalters (54) zum Anwenden des dritten Eingangssignals (VR2) auf das Gate des zweiten Transistors (38),
bei dem sich die ersten, zweiten und dritten Eingangssignale (DI, VR1, VR2) voneinander unterscheiden,
- und Steuern der ersten bis vierten Schalter (51, 52, 53, 54) so, daß die beiden ersten und zweiten Transistoren (36, 38) nicht leitend sind oder die beiden ersten und zweiten Transistoren (36, 38) leitend sind oder entweder der erste Transistor (36) oder der zweite Transistor (38) leitend ist.

## Revendications

1. Circuit d'interface qui est connecté à une unité fonctionnelle (2), comprenant:
- une section de circuit fonctionnel (32) comprenant:
-- un premier et un deuxième transistor (36, 38) connectés en série; et
-- une partie connectée intermédiaire (42) entre ledit premier transistor (36) et ledit deuxième transistor (38), à laquelle est connectée ladite unité fonctionnelle (2);
- une borne externe (44), formée au niveau de ladite partie connectée intermédiaire;
- un premier interrupteur (51) apte à choisir un premier signal d'entrée (DI) et à transmettre ledit premier signal d'entrée à la grille dudit premier transistor (36);
- un deuxième interrupteur (52) apte à choisir un deuxième signal d'entrée (VR1) et à transmettre ledit deuxième signal d'entrée à la grille dudit premier transistor (36);
- un troisième interrupteur (53) apte à choisir ledit premier signal d'entrée (DI) et à transmettre ledit premier signal d'entrée à la grille dudit deuxième transistor (38); et
- un quatrième interrupteur (54) apte à choisir un troisième signal d'entrée (VR2) et à transmettre ledit troisième signal d'entrée à la grille dudit deuxième transistor (38),
- lesdits premier, deuxième et troisième signaux d'entrée (DI, VR1, VR2) étant différents les uns des autres;
- une section de commande d'interrupteurs (60) apte à recevoir deux signaux d'entrée de commande (C11, C12) et à commander lesdits premier, deuxième, troisième et quatrième interrupteurs (51, 52, 53, 54) de façon que lesdits premier et deuxième transistors (36, 38) soient tous les deux non conducteurs ou que lesdits premier et deuxième transistors (36, 38) soient tous les deux conducteurs ou que l'un ou l'autre dudit premier transistor (36) ou dudit deuxième transistor (38) soit conducteur.

2. Circuit d'interface selon la revendication 1, dans lequel ledit premier signal d'entrée (DI) est un signal d'entrée d'attaque, ledit deuxième signal d'entrée (VR1) est un signal d'entrée de polarisation et ledit troisième signal d'entrée (VR2) est un signal d'entrée de polarisation.

3. Circuit d'interface selon la revendication 1, pourvu, sur un côté, d'un régisseur (4) connecté à une mémoire (2),
- dans lequel ladite mémoire (2) est connectée à ladite borne externe (44) en tant que ladite unité fonctionnelle (2).

4. Procédé de mise en oeuvre d'un circuit d'interface selon l'une quelconque des revendications précédentes, ledit procédé de mise en oeuvre étant **caractérisé en ce qu'**il comprend:
- l'utilisation du premier interrupteur (51) pour appliquer le premier signal d'entrée (DI) à la grille dudit premier transistor (36);
- l'utilisation du deuxième interrupteur (52) pour appliquer le deuxième signal d'entrée (VR1) à la grille dudit premier transistor (36);
- l'utilisation du troisième interrupteur (53) pour appliquer ledit premier signal d'entrée (DI) à la grille dudit deuxième transistor (38); et
- l'utilisation du quatrième interrupteur (54) pour appliquer le troisième signal d'entrée (VR2) à la grille dudit deuxième transistor (38),
dans lequel lesdits premier, deuxième et troisième signaux d'entrée (DI, VR1, VR2) étant différents les uns des autres;
- la commande desdits premier, deuxième, troisième et quatrième interrupteurs (51, 52, 53, 54) de façon que lesdits premier et deuxième transistors (36, 38) soient tous les deux non conducteurs ou que lesdits premier et deuxième transistors (36, 38) soient tous les deux conducteurs ou que l'un ou l'autre dudit premier transistor (36) ou dudit deuxième transistor (38) soit conducteur.
